# EUROPEAN PATENT SPECIFICATION

(11) **EP 1 791 025 B1**
(45) Date of publication and mention of the grant of the patent: **12.06.2013**
(21) Application number: 06255530.5
(22) Date of filing: 26.10.2006
(51) Int. Cl.: G03F 7/038

(54) **Negative resist composition and patterning process**
Negativ arbeitende Resist-Zusammensetzung und Bildaufzeichnungsverfahren
Composition pour réserve de type négatif et procédé d'enregistrement d'images

(30) Priority: 17.11.2005 JP 2005333135
(43) Date of publication of application: 30.05.2007
(60) Divisional application: 09011118.8
(73) Proprietor: Shin-Etsu Chemical Co., Ltd., Tokyo (JP)
(72) Inventor: Takeda, Takanobu, Joetsu-shi, Niigata-ken (JP); Watanabe, Osamu, Joetsu-shi, Niigata-ken (JP); Watanabe, Satoshi,, Joetsu-shi, Niigata-ken (JP); Koitabashi, Ryuji, Joetsu-shi, Niigata-ken (JP); Watanabe, Tamotsu, Joetsu-shi, Niigata-ken (JP)
(74) Representative: Stoner, Gerard Patrick

(56) References cited:
- EP-A- 1 285 751
- JP-A- 10 016 423
- JP-A- 2001 174 994
- JP-A- 2003 295 437
- JP-A- 2004 101 811
- US-B2- 6 861 198

## Description

This invention relates to negative resist compositions comprising as base resin a polymer obtainable by copolymerizing vinylbenzoic acid with a monomer having an alkali solubility or a structure capable of converting to a functional group having an alkali solubility through deprotection reaction and effecting deprotection reaction. Exemplary compositions show high contrast of alkali dissolution rate before and after exposure, a high resolution, and good etching resistance and are useful as the micropatterning material for VLSI manufacture and mask pattern forming material. Another aspect relates to patterning processes using such negative resist compositions.

### BACKGROUND

While a number of recent efforts are being made to achieve a finer pattern rule in the drive for higher integration and operating speeds in LSI devices, deep-ultraviolet lithography is thought to hold particular promise as the next generation in microfabrication technology. Deep-UV lithography is capable of achieving a feature size of 0.5 µm or less and, when a resist having low light absorption is used, can form patterns with sidewalls that are nearly perpendicular to the substrate.

Recently developed acid-catalyzed chemical amplification positive resists, such as those described in JP-B 2-27660, JP-A 63-27829, USP 4,491,628 and USP 5,310,619, utilize a high-intensity KrF excimer laser as the deep-UV light source. These resists, with their excellent properties such as high sensitivity, high resolution, and good dry etching resistance, are especially promising for deep-UV lithography.

While a current focus is placed on the electron beam lithography due to its ability to achieve a feature size of 0.1 µm or less, a chemically amplified negative resist composition comprising a crosslinker with improved pattern size definition is deemed attractive, and becomes an essential mask pattern forming material as well. Negative resist compositions using copolymers of hydroxystyrene with styrene or alkoxystyrene as a base resin were reported.

These resist compositions, however, suffer from several problems. The pattern profile often takes a bridge shape. The resins having bulky groups on alkoxystyrene side chains are low in heat resistance and unsatisfactory in sensitivity and resolution. In addition, the chemically amplified negative resist compositions are unsatisfactory in resolution, as compared with the chemically amplified positive resist compositions.

While the technology brings the resolution to a level of 0.07 µm or less, a challenge is simultaneously made to reduce the thickness of pattern-forming films. There is a need for a resist material having higher etching resistance.

Our US6861198B2 describes negative resist materials comprising a polymer with the following repeat units: 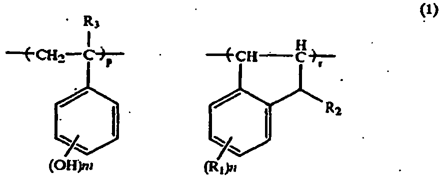 were R₁ and R₂ are H, OH, alkyl or alkoxy and R₃ is H or methyl, n is 0 or 1 to 4, m is 0 or 1 to 5, p is 0 or positive and r is positive. The weight average molecular weight is from 1,000 to 500,000. Acrylate repeat units may be included.

An object of the invention is to provide new and useful negative resist compositions, especially chemically amplified negative resist compositions. Preferred aims include higher resolution than prior art compositions, forming a better pattern profile after exposure, and offering excellent dry etching resistance. Other aspects of the invention include the provision of processes for forming a resist pattern using such resist compositions.

It has been found that a polymer comprising recurring units of the general formula (2) shown below, and having a weight average molecular weight of 1,000 to 500,000, especially 2,000 to 6,000 is an effective base resin in a negative resist composition, especially chemically amplified negative resist compositions. We find that such negative resist compositions, containing crosslinker, photoacid generator and organic solvent as well as the polymer, can form a resist film having many advantages including an increased dissolution contrast, high resolution, exposure latitude, process adaptability, a good pattern profile after exposure, and excellent etching resistance. The composition is thus suited for practical use and advantageously used as a resist material for VLSI manufacture.

A first aspect of the invention is a negative resist composition comprising a polymer comprising recurring units having the general formula (2) and having a weight average molecular weight of 1,000 to 500,000. 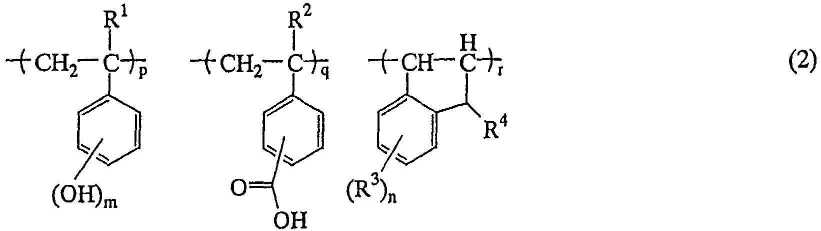 Herein R¹ and R² are hydrogen or methyl, R³ and R⁴ are independently selected from the class consisting of hydrogen atoms, hydroxy groups, methyl groups, alkoxycarbonyl groups, cyano groups and halogen atoms, m is 0 or a positive integer of 1 to 5, n is 0 or a positive integer of 1 to 4, and p, q and r are positive numbers.

Preferably, the polymers of formula (2) have a weight average molecular weight of 2,000 to 6,000.

In another aspect, the invention provides a chemically amplified negative resist composition comprising (A) an organic solvent, (B) the polymer of formula (2) as a base resin, (C) a crosslinker, and optionally (D) a photoacid generator and/or (E) a basic compound.

In a further aspect, the invention provides a process for forming a resist pattern, comprising the steps of applying the resist composition onto a substrate to form a coating; heat treating the coating and exposing the coating to high-energy radiation or electron beam through a photomask; optionally heat treating the exposed coating, and developing the coating with a developer.

### BENEFITS

The present invention uses a polymer obtainable by **copolymerizing vinylbenzoic acid with a monomer having an alkali solubility or a structure capable of converting to a functional group having an alkali solubility through deprotection reaction and effecting deprotection reaction, and formulates it as a base resin to give a negative resist** composition. This is found to exhibit a high contrast of **alkali dissolution rate before and after exposure, a high resolution, and excellent etching resistance. The composition is advantageously used as the micropatterning material for VLSI manufacture and mask pattern forming material.**

### FURTHER EXPLANATIONS; OPTIONS AND PREFERENCES

### Polymer

**The negative resist composition of the invention comprises a polymer or high molecular weight compound comprising recurring units of the general formula (2), shown below, and having a weight average molecular weight of 1,000 to 500,000.** 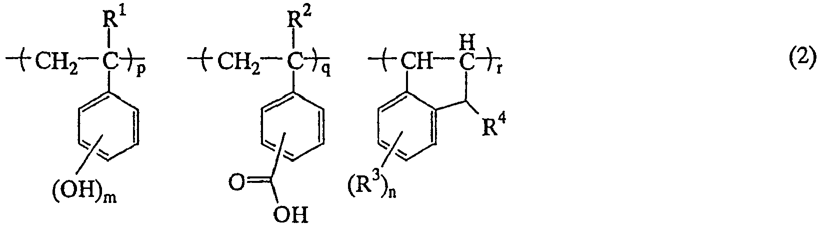 Herein R¹ and R², are hydrogen or methyl. R³ and R⁴ are independently selected from among hydrogen atoms, hydroxy groups, methyl groups, alkoxycarbonyl groups, cyano groups, and halogen atoms. The subscript m is 0 or a positive integer of 1 to 5, n is 0 or a positive integer of 1 to 4, and p, q and r are positive numbers.

When R³ and R⁴ stand for halogen atoms, exemplary halogen atoms are fluorine, chlorine and bromine.

When R³ and R⁴, stand for alkoxy or alkoxycarbonyl groups, suitable alkoxy groups are those of 1 to 6 carbon atoms, especially 1 to 4 carbon atoms, such as methoxy and isopropoxy.

In the above formulae, p and q are positive numbers in the range: 0 < p/(p+q) < 1 and 0 < q/(p+q) < 1, preferably 0.01 ≤ q/(p+q) s 0.10, and more preferably 0.01 ≤ q/(p+q) s 0.07. In formula (2), p, q and r are positive numbers, preferably satisfying 0 < q/(p+q+r) ≤ 0.1, more preferably 0.01 ≤ q/(p+q+r) s 0.07, and 0 < r/(p+q+r) ≤ 0.2. If q=0, that is, if the polymer does not contain the q-suffixed units, the desired resolution enhancement effect is lost. Too high a proportion of q may lead to too high an alkali dissolution rate in unexposed areas and a loss of contrast. The r-suffixed units serve to improve the etching resistance of polymers, but too high a proportion of r may lead to too low an alkali dissolution rate in unexposed areas, causing defects after development.

It is noted that p+q+r ≤ 1 in formula (2). Formula (2) may further include styrene units having pendant adhesive groups. Unity, i.e. p+q+r=1 in formula (2) means that the total of recurring units p, q and r is 100 mol% based on the total of entire recurring units.

A proper choice of p, q and r, in the above ranges enables to control the resolution, dry etching resistance and pattern profile of the resist composition as desired.

The polymers should have a weight average molecular weight (Mw) of 1,000 to 500,000, and preferably 2,000 to 6,000, as measured by gel permeation chromatography (GPC) versus polystyrene standards. With too low a Mw, the resist composition may become less heat resistant. Too high a Mw adversely affects the alkali dissolution in unexposed areas, increases a tendency for a footing phenomenon to occur after pattern formation, and detracts from resolution.

For the synthesis of the inventive polymers, one method involves adding acetoxystyrene and vinylbenzoic acid monomers with indene monomer to an organic solvent, adding a radical initiator, effecting heat polymerization, and subjecting the resulting polymer in the organic solvent to alkaline hydrolysis for deprotecting acetoxy groups, thereby forming a ternary copolymer of hydroxystyrene, vinylbenzoic acid and indene can be synthesized.

Examples of the organic solvent which can be used during the polymerization include toluene, benzene, tetrahydrofuran, diethyl ether, dioxane, and the like. Suitable polymerization initiators include 2,2'-azobisisobutyronitrile, 2,2'-azobis(2,4-dimethylvaleronitrile), dimethyl 2,2-azobis(2-methylpropionate), benzoyl peroxide, lauroyl peroxide, and the like. Polymerization is preferably effected by heating at 40 to 70°C. The reaction time is usually about 2 to 100 hours, preferably about 5 to 40 hours. The bases used for alkaline hydrolysis include aqueous ammonia and triethylamine. For the hydrolysis, the reaction temperature is usually -20°C to 100°C, preferably 0°C to 60°C, and the reaction time is usually about 0.2 to 100 hours, preferably about 0.5 to 20 hours. It is noted that the synthesis procedure is not limited to the aforementioned.

### Organic solvent

In the chemically amplified negative resist composition of the invention, an organic solvent is used as component (A). Illustrative, non-limiting, examples include butyl acetate, amyl acetate, cyclohexyl acetate, 3-methoxybutyl acetate, methyl ethyl ketone, methyl amyl ketone, cyclohexanone, cyclopentanone, 3-ethoxyethyl propionate, 3-ethoxymethyl propionate, 3-methoxymethyl propionate, methyl acetoacetate, ethyl acetoacetate, diacetone alcohol, methyl pyruvate, ethyl pyruvate, propylene glycol monomethyl ether, propylene glycol monoethyl ether, propylene glycol monomethyl ether propionate, propylene glycol monoethyl ether propionate, ethylene glycol monomethyl ether, ethylene glycol monoethyl ether, diethylene glycol monomethyl ether, diethylene glycol monoethyl ether, 3-methyl-3-methoxybutanol, N-methylpyrrolidone, dimethyl sulfoxide, γ-butyrolactone, propylene glycol alkyl ether acetates such as propylene glycol methyl ether acetate, propylene glycol ethyl ether acetate, and propylene glycol propyl ether acetate, alkyl lactates such as methyl lactate, ethyl lactate, and propyl lactate, and tetramethylene sulfone. Of these, the propylene glycol alkyl ether acetates and alkyl lactates are especially preferred. The solvents may be used alone or in admixture of two or more.

An exemplary useful solvent mixture is a mixture of propylene glycol alkyl ether acetates and/or alkyl lactates. It is noted that the alkyl groups of the propylene glycol alkyl ether acetates are preferably those of 1 to 4 carbon atoms, for example, methyl, ethyl and propyl, with methyl and ethyl being especially preferred. Since the propylene glycol alkyl ether acetates include 1,2- and 1,3-substituted ones, each includes three isomers depending on the combination of substituted positions, which may be used alone or in admixture. It is also noted that the alkyl groups of the alkyl lactates are preferably those of 1 to 4 carbon atoms, for example, methyl, ethyl and propyl, with methyl and ethyl being especially preferred.

When the propylene glycol alkyl ether acetate is used as the solvent, it preferably accounts for at least 50% by weight of the entire solvent. Also when the alkyl lactate is used as the solvent, it preferably accounts for at least 50% by weight of the entire solvent. When a mixture of propylene glycol alkyl ether acetate and alkyl lactate is used as the solvent, that mixture preferably accounts for at least 50% by weight of the entire solvent. In this solvent mixture, it is further preferred that the propylene glycol alkyl ether acetate is 60 to 95% by weight and the alkyl lactate is 5 to 40% by weight. A lower proportion of the propylene glycol alkyl ether acetate would invite a problem of inefficient coating whereas a higher proportion thereof would provide insufficient dissolution and allow for particle and foreign matter formation. A lower proportion of the alkyl lactate would provide insufficient dissolution and cause the problem of many particles and foreign matter whereas a higher proportion thereof would lead to a composition which has a too high viscosity to apply and loses storage stability.

In the negative resist composition, the solvent is preferably used in an amount of 300 to 2,000 parts by weight, especially 400 to 1,000 parts by weight per 100 parts by weight of the solids. The concentration of the resulting composition is not limited thereto as long as a film can be formed by existing methods.

### Crosslinker

The crosslinker used herein as component (C) may be any of crosslinkers which induce intramolecular and intermolecular crosslinkage to the polymer with the aid of the acid generated by the photoacid generator as component (D) or directly in response to light. Suitable crosslinkers include bisazides, alkoxymethylglycolurils, and alkoxymethylmelamines.

Examples of suitable bisazides include 4,4'-diazidophenyl sulfide, bis(4-azidobenzyl)methane, bis(3-chloro-4-azidobenzyl)methane, bis-4-azidobenzylidene, 2,6-bis(4-azidobenzylidene)-cyclohexanone, and 2,6-bis(4-azidobenzylidene)-4-methylcyclohexanone. Examples of suitable alkoxymethylglycolurils include tetramethoxymethylglycoluril, 1,3-bismethoxymethyl-4,5-bismethoxyethylene urea, and bismethoxymethyl urea. Examples of suitable alkoxymethylmelamines include hexamethoxymethylmelamine and hexaethoxymethylmelamine.

In the negative resist composition of the invention, the crosslinker is preferably added in an amount of 2 to 40 parts by weight, more preferably 5 to 20 parts by weight per 100 parts by weight of the base resin. The crosslinkers may be used alone or in admixture of two or more. The transmittance of the resist film can be controlled by using a crosslinker having a low transmittance at the exposure wavelength and adjusting the amount of the crosslinker added.

### Photoacid generator

The photoacid generator may be any of compounds which generate acid upon exposure to high-energy radiation. Suitable photoacid generators include sulfonium salts, iodonium salts, sulfonyldiazomethane and N-sulfonyloxyimide photoacid generators. Exemplary photoacid generators are given below while they may be used alone or in admixture of two or more.

Sulfonium salts are salts of sulfonium cations with sulfonate anions. Exemplary sulfonium cations include triphenylsulfonium, (4-tert-butoxyphenyl)diphenylsulfonium, bis(4-tert-butoxyphenyl)phenylsulfonium, tris(4-tert-butoxyphenyl)sulfonium, (3-tert-butoxyphenyl)diphenylsulfonium, bis(3-tert-butoxyphenyl)phenylsulfonium, tris(3-tert-butoxyphenyl)sulfonium, (3,4-di-tert-butoxyphenyl)diphenylsulfonium, bis(3,4-di-tert-butoxyphenyl)phenylsulfonium, tris(3,4-di-tert-butoxyphenyl)sulfonium, diphenyl(4-thiophenoxyphenyl)sulfonium, (4-tert-butoxycarbonylmethyloxyphenyl)diphenylsulfonium, tris(4-tert-butoxycarbonylmethyloxyphenyl)sulfonium, (4-tert-butoxyphenyl)bis(4-dimethylaminophenyl)sulfonium, tris(4-dimethylaminophenyl)sulfonium, 2-naphthyldiphenylsulfonium, dimethyl-2-naphthylsulfonium, 4-hydroxyphenyldimethylsulfonium, 4-methoxyphenyldimethylsulfonium, trimethylsulfonium, 2-oxocyclohexylcyclohexylmethylsulfonium, trinaphthylsulfonium, and tribenzylsulfonium. Exemplary sulfonate anions include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, and methanesulfonate. Sulfonium salts based on combination of the foregoing examples are included.

Iodinium salts are salts of iodonium cations with sulfonate anions. Exemplary iodonium cations are aryliodonium cations including diphenyliodinium, bis(4-tert-butylphenyl)iodonium, 4-tert-butoxyphenylphenyliodonium, and 4-methoxyphenylphenyliodonium. Exemplary sulfonate anions include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, and methanesulfonate. Iodonium salts based on combination of the foregoing examples are included.

Exemplary sulfonyldiazomethane compounds include bissulfonyldiazomethane compounds and sulfonyl-carbonyldiazomethane compounds such as bis(ethylsulfonyl)diazomethane, bis(l-methylpropylsulfonyl)diazomethane, bis(2-methylpropylsulfonyl)diazomethane, bis(1,1-dimethylethylsulfonyl)diazomethane, bis(cyclohexylsulfonyl)diazomethane, bis(perfluoroisopropylsulfonyl)diazomethane, bis(phenylsulfonyl)diazomethane, bis(4-methylphenylsulfonyl)diazomethane, bis(2,4-dimethylphenylsulfonyl)diazomethane, bis(2-naphthylsulfonyl)diazomethane, 4-methylphenylsulfonylbenzoyldiazomethane, tert-butylcarbonyl-4-methylphenylsulfonyldiazomethane, 2-naphthylsulfonylbenzoyldiazomethane, 4-methylphenylsulfonyl-2-naphthoyldiazomethane, methylsulfonylbenzoyldiazomethane, and tert-butoxycarbonyl-4-methylphenylsulfonyldiazomethane.

N-sulfonyloxyimide photoacid generators include combinations of imide skeletons with sulfonate skeletons. Exemplary imide skeletons are succinimide, naphthalene dicarboxylic acid imide, phthalimide, cyclohexyldicarboxylic acid imide, 5-norbornene-2,3-dicarboxylic acid imide, and 7-oxabicyclo[2.2.1]-5-heptene-2,3-dicarboxylic acid imide. Exemplary sulfonate skeletons include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, and methanesulfonate.

Additionally, other photoacid generators as listed below are useful. Benzoinsulfonate photoacid generators include benzoin tosylate, benzoin mesylate, and benzoin butanesulfonate.

Pyrogallol trisulfonate photoacid generators include pyrogallol, phloroglycine, catechol, resorcinol, hydroquinone, in which all the hydroxyl groups are substituted with sulfonate groups such as trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, and methanesulfonate.

Nitrobenzyl sulfonate photoacid generators include 2,4-dinitrobenzyl sulfonate, 2-nitrobenzyl sulfonate, and 2,6-dinitrobenzyl sulfonate, with exemplary sulfonates including trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, and methanesulfonate. Also useful are analogous nitrobenzyl sulfonate compounds in which the nitro group on the benzyl side is substituted by a trifluoromethyl group.

Sulfone photoacid generators include
bis(phenylsulfonyl)methane,
bis(4-methylphenylsulfonyl)methane,
bis(2-naphthylsulfonyl)methane,
2,2-bis(phenylsulfonyl)propane,
2,2-bis(4-methylphenylsulfonyl)propane,
2,2-bis(2-naphthylsulfonyl)propane,
2-methyl-2-(p-toluenesulfonyl)propiophenone,
2-cyclohexylcarbonyl-2-(p-toluenesulfonyl)propane, and
2,4-dimethyl-2-(p-toluenesulfonyl)pentan-3-one.

Photoacid generators in the form of glyoxime derivatives include
bis-O-(p-toluenesulfonyl)-a-dimethylglyoxime,
bis-O-(p-toluenesulfonyl)-a-diphenylglyoxime,
bis-O-(p-toluenesulfonyl)-α-dicyclohexylglyoxime,
bis-O-(p-toluenesulfonyl)-2,3-pentanedioneglyoxime,
bis-O-(p-toluenesulfonyl)-2-methyl-2,3-pentanedioneglyoxime,
bis-O-(n-butanesulfonyl)-a-dimethylglyoxime,
bis-O-(n-butanesulfonyl)-α-diphenylglyoxime,
bis-O-(n-butanesulfonyl)-a-dicyclohexylglyoxime,
bis-O-(n-butanesulfonyl)-2,3-pentanedioneglyoxime,
bis-O-(n-butanesulfonyl)-2-methyl-3,4-pentanedioneglyoxime,
bis-O-(methanesulfonyl)-α-dimethylglyoxime,
bis-O-(trifluoromethanesulfonyl)-α-dimethylglyoxime,
bis-O-(1,1,1-trifluoroethanesulfonyl)-α-dimethylglyoxime,
bis-O-(tert-butanesulfonyl)-α-dimethylglyoxime,
bis-O-(perfluorooctanesulfonyl)-α-dimethylglyoxime,
bis-O-(cyclohexylsulfonyl)-α-dimethylglyoxime,
bis-O-(benzenesulfonyl)-α-dimethylglyoxime,
bis-O-(p-fluorobenzenesulfonyl)-α-dimethylglyoxime,
bis-O-(p-tert-butylbenzenesulfonyl)-α-dimethylglyoxime,
bis-O-(xylenesuifonyl)-α-dimethylglyoxime, and
bis-O-(camphorsulfonyl)-α-dimethylglyoxime.

Of these, sulfonium salt, bissulfonyldiazomethane and N-sulfonyloxyimide photoacid generators are preferred.

While the anion of an optimum photoacid generator varies depending on ease of scission of acid labile groups on the polymer, it is generally selected from those anions which are nonvolatile and not extremely diffusive. Suitable anions include benzenesulfonate, toluenesulfonate, 4-(4-toluenesulfonyloxy)benzenesulfonate, pentafluorobenzenesulfonate, 2,2,2-trifluoroethanesulfonate, nonafluorobutanesulfonate, heptadecafluorooctanesulfonate, and camphorsulfonate anions.

In the negative resist composition of the invention, the photoacid generator is preferably added in an amount of 0 to 20 parts by weight, more preferably 1 to 10 parts by weight per 100 parts by weight of the base resin. The photoacid generators may be used alone or in admixture of two or more. The transmittance of the resist film can be controlled by using a photoacid generator having a low transmittance at the exposure wavelength and adjusting the amount of the photoacid generator added.

### Basic compound

In the chemically amplified negative resist composition, a basic compound may be added as component (E). The basic compound used herein is preferably a compound capable of suppressing the rate of diffusion when the acid generated by the photoacid generator diffuses within the resist film. The inclusion of this type of basic compound holds down the rate of acid diffusion within the resist film, resulting in better resolution. In addition, it suppresses changes in sensitivity following exposure and reduces substrate and environment dependence, as well as improving the exposure latitude and the pattern profile.

Examples of basic compounds include primary, secondary, and tertiary aliphatic amines, mixed amines, aromatic amines, heterocyclic amines, nitrogen-containing compounds having carboxyl group, nitrogen-containing compounds having sulfonyl group, nitrogen-containing compounds having hydroxyl group, nitrogen-containing compounds having hydroxyphenyl group, alcoholic nitrogen-containing compounds, amide derivatives, and imide derivatives.

Examples of suitable primary aliphatic amines include ammonia, methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, and tetraethylenepentamine. Examples of suitable secondary aliphatic amines include dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, and N,N-dimethyltetraethylenepentamine. Examples of suitable tertiary aliphatic amines include trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, and N,N,N',N'-tetramethyltetraethylenepentamine.

Examples of suitable mixed amines include dimethylethylamine, methylethylpropylamine, benzylamine, phenethylamine, and benzyldimethylamine.

Examples of suitable aromatic and heterocyclic amines include aniline derivatives (e.g., aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, and N,N-dimethyltoluidine), diphenyl(p-tolyl)amine, methyldiphenylamine, triphenylamine, phenylenediamine, naphthylamine, diaminonaphthalene, pyrrole derivatives (e.g., pyrrole, 2H-pyrrole, 1-methylpyrrole, 2,4-dimethylpyrrole, 2,5-dimethylpyrrole, and N-methylpyrrole), oxazole derivatives (e.g., oxazole and isooxazole), thiazole derivatives (e.g., thiazole and isothiazole), imidazole derivatives (e.g., imidazole, 4-methylimidazole, and 4-methyl-2-phenylimidazole), pyrazole derivatives, furazan derivatives, pyrroline derivatives (e.g., pyrroline and 2-methyl-l-pyrroline), pyrrolidine derivatives (e.g., pyrrolidine, N-methylpyrrolidine, pyrrolidinone, and N-methylpyrrolidone), imidazoline derivatives, imidazolidine derivatives, pyridine derivatives (e.g., pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridine, 4-pyrrolidinopyridine, 1-methyl-4-phenylpyridine, 2-(1-ethylpropyl)pyridine, aminopyridine, and dimethylaminopyridine), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (e.g., quinoline and 3-quinolinecarbonitrile), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, and uridine derivatives.

Examples of suitable nitrogen-containing compounds with carboxyl group include aminobenzoic acid, indolecarboxylic acid, and amino acid derivatives (e.g. nicotinic acid, alanine, alginine, aspartic acid, glutamic acid, glycine, histidine, isoleucine, glycylleucine, leucine, methionine, phenylalanine, threonine, lysine, 3-aminopyrazine-2-carboxylic acid, and methoxyalanine). Examples of suitable nitrogen-containing compounds with sulfonyl group include 3-pyridinesulfonic acid and pyridinium p-toluenesulfonate. Examples of suitable nitrogen-containing compounds with hydroxyl group, nitrogen-containing compounds with hydroxyphenyl group, and alcoholic nitrogen-containing compounds include 2-hydroxypyridine, aminocresol, 2,4-quinolinediol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl)piperazine, 1-[2-(2-hydroxyethoxy)ethyl]piperazine, piperidine ethanol, 1-(2-hydroxyethyl)pyrrolidine, 1-(2-hydroxyethyl)-2-pyrrolidinone, 3-piperidino-1,2-propanediol, 3-pyrrolidino-1,2-propanediol, 8-hydroxyjulolidine, 3-quinuclidinol, 3-tropanol, 1-methyl-2-pyrrolidine ethanol, 1-aziridine ethanol, N-(2-hydroxyethyl)phthalimide, and N-(2-hydroxyethyl)isonicotinamide.

Examples of suitable amide derivatives include formamide, N-methylformamide, N,N-dimethylformamide, acetamide, N-methylacetamide, N,N-dimethylacetamide, propionamide, and benzamide. Suitable imide derivatives include phthalimide, succinimide, and maleimide.

In addition, one or more of basic compounds of the following general formula (E)-1 may also be included.

N(X)_{n'}(Y)_{3-n'} (E)-1

In the formula, n' is equal to 1, 2 or 3; side chain Y is independently hydrogen or a straight, branched or cyclic alkyl group of 1 to 20 carbon atoms which may contain a hydroxyl group or ether group; and side chain X is independently selected from groups of the following general formulas (X)-1 to (X)-3, and two or three X may bond together to form a ring.

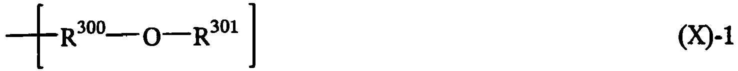

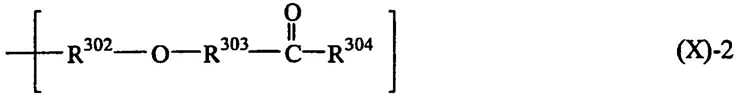

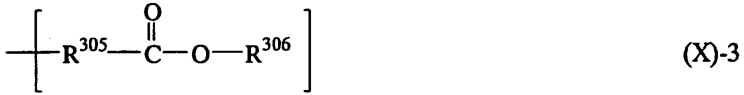

In the formulas, R³⁰⁰, R³⁰² and R³⁰⁵ are independently straight or branched alkylene groups of 1 to 4 carbon atoms; R³⁰¹ and R³⁰⁴ are independently hydrogen or straight, branched or cyclic alkyl groups of 1 to 20 carbon atoms, which may contain at least one hydroxyl group, ether group, ester group or lactone ring; R³⁰³ is a single bond or a straight or branched alkylene group of 1 to 4 carbon atoms; and R³⁰⁶ is a straight, branched or cyclic alkyl group of 1 to 20 carbon atoms, which may contain at least one hydroxyl group, ether group, ester group or lactone ring.

Illustrative examples of the basic compounds of formula (E)-1 include, but are not limited to,
tris[(2-methoxymethoxy)ethyl]amine,
tris[2-(2-methoxyethoxy)ethyl]amine,
tris[2-(2-methoxyethoxymethoxy)ethyl]amine,
tris[2-(1-methoxyethoxy)ethyl]amine,
tris[2-(1-ethoxyethoxy)ethyl]amine,
tris[2-(1-ethoxypropoxy)ethyl]amine,
tris[2-{2-(2-hydroxyethoxy)ethoxy}ethyl]amine,
4,7,13,16,21,24-hexaoxa-1,10-diazabicyclo[8.8.8]hexacosane,
4,7,13,18-tetraoxa-1,10-diazabicyclo[8.5.5]eicosane,
1,4,10,13-tetraoxa-7,16-diazabicyclooctadecane,
1-aza-12-crown-4, 1-aza-15-crown-5, 1-aza-18-crown-6,
tris(2-formyloxyethyl)amine, tris(2-acetoxyethyl)amine,
tris(2-propionyloxyethyl)amine, tris(2-butyryloxyethyl)amine,
tris(2-isobutyryloxyethyl)amine, tris(2-valeryloxyethyl)amine,
tris(2-pivaloyloxyethyl)amine,
N,N-bis(2-acetoxyethyl)-2-(acetoxyacetoxy)ethylamine,
tris(2-methoxycarbonyloxyethyl)amine,
tris(2-tert-butoxycarbonyloxyethyl)amine,
tris[2-(2-oxopropoxy)ethyl]amine,
tris[2-(methoxycarbonylmethyl)oxyethyl]amine,
tris[2-(tert-butoxycarbonylmethyloxy)ethyl]amine,
tris[2-(cyclohexyloxycarbonylmethyloxy)ethyl]amine,
tris(2-methoxycarbonylethyl)amine,
tris(2-ethoxycarbonylethyl)amine,
N,N-bis(2-hydroxyethyl)-2-(methoxycarbonyl)ethylamine,
N,N-bis(2-acetoxyethyl)-2-(methoxycarbonyl)ethylamine,
N,N-bis(2-hydroxyethyl)-2-(ethoxycarbonyl)ethylamine,
N,N-bis(2-acetoxyethyl)-2-(ethoxycarbonyl)ethylamine,
N,N-bis(2-hydroxyethyl)-2-(2-methoxyethoxycarbonyl)ethylamine,
N,N-bis(2-acetoxyethyl)-2-(2-methoxyethoxycarbonyl)ethylamine,
N,N-bis(2-hydroxyethyl)-2-(2-hydroxyethoxycarbonyl)ethylamine,
N,N-bis(2-acetoxyethyl)-2-(2-acetoxyethoxycarbonyl)ethylamine,
N,N-bis(2-hydroxyethyl)-2-[(methoxycarbonyl)methoxycarbonyl]-ethylamine,
N,N-bis(2-acetoxyethyl)-2-[(methoxycarbonyl)methoxycarbonyl]-ethylamine,
N,N-bis(2-hydroxyethyl)-2-(2-oxopropoxycarbonyl)ethylamine,
N,N-bis(2-acetoxyethyl)-2-(2-oxopropoxycarbonyl)ethylamine,
N,N-bis(2-hydroxyethyl)-2-(tetrahydrofurfuryloxycarbonyl)-ethylamine,
N,N-bis(2-acetoxyethyl)-2-(tetrahydrofurfuryloxycarbonyl)-ethylamine,
N,N-bis(2-hydroxyethyl)-2-[(2-oxotetrahydrofuran-3-yl)oxycarbonyl]ethylamine,
N,N-bis(2-acetoxyethyl)-2-[(2-oxotetrahydrofuran-3-yl)oxycarbonyl]ethylamine,
N,N-bis(2-hydroxyethyl)-2-(4-hydroxybutoxycarbonyl)ethylamine,
N,N-bis(2-formyloxyethyl)-2-(4-formyloxybutoxycarbonyl)-ethylamine,
N,N-bis(2-formyloxyethyl)-2-(2-formyloxyethoxycarbonyl)-ethylamine,
N,N-bis(2-methoxyethyl)-2-(methoxycarbonyl)ethylamine,
N-(2-hydroxyethyl)-bis[2-(methoxycarbonyl)ethyl]amine,
N-(2-acetoxyethyl)-bis[2-(methoxycarbonyl)ethyl]amine,
N-(2-hydroxyethyl)-bis[2-(ethoxycarbonyl)ethyl]amine,
N-(2-acetoxyethyl)-bis[2-(ethoxycarbonyl)ethyl]amine,
N-(3-hydroxy-1-propyl)-bis[2-(methoxycarbonyl)ethyl]amine,
N-(3-acetoxy-1-propyl)-bis[2-(methoxycarbonyl)ethyl]amine,
N-(2-methoxyethyl)-bis[2-(methoxycarbonyl)ethyl]amine,
N-butyl-bis[2-(methoxycarbonyl)ethyl]amine,
N-butyl-bis[2-(2-methoxyethoxycarbonyl)ethyl]amine,
N-methyl-bis(2-acetoxyethyl)amine,
N-ethyl-bis(2-acetoxyethyl)amine,
N-methyl-bis(2-pivaloyloxyethyl)amine,
N-ethyl-bis[2-(methoxycarbonyloxy)ethyl]amine,
N-ethyl-bis[2-(tert-butoxycarbonyloxy)ethyl]amine,
tris(methoxycarbonylmethyl)amine,
tris(ethoxycarbonylmethyl)amine,
N-butyl-bis(methoxycarbonylmethyl)amine,
N-hexyl-bis(methoxycarbonylmethyl)amine, and
β-(diethylamino)-δ-valerolactone.

The basic compounds may be used alone or in admixture of two or more. The basic compound is preferably formulated in an amount of 0 to 2 parts, and especially 0.01 to 1 part by weight, per 100 parts by weight of the base resin in the resist composition. The use of more than 2 parts of the basis compound may result in too low a sensitivity.

### Surfactant

In the chemically amplified negative resist composition of the invention, a surfactant may be added for improving coating characteristics.

Illustrative, non-limiting, examples of the surfactant include nonionic surfactants, for example, polyoxyethylene alkyl ethers such as polyoxyethylene lauryl ether, polyoxyethylene stearyl ether, polyoxyethylene cetyl ether, and polyoxyethylene oleyl ether, polyoxyethylene alkylaryl ethers such as polyoxyethylene octylphenol ether and polyoxyethylene nonylphenol ether, polyoxyethylene polyoxypropylene block copolymers, sorbitan fatty acid esters such as sorbitan monolaurate, sorbitan monopalmitate, and sorbitan monostearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorochemical surfactants such as EFTOP EF301, EF303 and EF352 (Tohkem Products Co., Ltd.), Megaface F171, F172 and F173 (Dainippon Ink & Chemicals, Inc.), Fluorad FC430 and FC431 (Sumitomo 3M Co., Ltd.), Aashiguard AG710, Surflon S-381, S-382, SC101, SC102, SC103, SC104, SC105, SC106, Surfynol E1004, KH-10, KH-20, KH-30 and KH-40 (Asahi Glass Co., Ltd.); organosiloxane polymers KP341, X-70-092 and X-70-093 (Shin-Etsu Chemical Co., Ltd.), acrylic acid or methacrylic acid Polyflow No. 75 and No. 95 (Kyoeisha Ushi Kagaku Kogyo K.K.). Inter alia, Fluorad FC430, Surflon S-381, Surfynol E1004, KH-20 and KH-30 are preferred. These surfactants may be used alone or in admixture.

In the chemically amplified negative resist composition, the surfactant is preferably formulated in an amount of up to 2 parts, and especially up to 1 part by weight, per 100 parts by weight of the base resin.

While the negative resist composition comprising (A) organic solvent, (B) polymer of formula (2), (C) crosslinker, (D) photoacid generator, and optional components is typically used in the microfabrication of many integrated circuits, any well-known lithography may be used to form a resist pattern from the resist composition.

In a typical process of forming a resist pattern from the negative resist composition of the invention, the composition is first applied onto a substrate by a coating technique. Suitable substrates include substrates for the microfabrication of integrated circuits, such as Si, SiO₂, SiN, SiON, TiN, WSi, BPSG, SOG, and organic antireflective films. Suitable coating techniques include spin coating, roll coating, flow coating, dip coating, spray coating, and doctor coating. The coating is then prebaked on a hot plate at a temperature of 60 to 150°C for about 1 to 10 minutes, preferably 80 to 120°C for about 1 to 5 minutes. The resulting resist film is generally 0.2 to 2.0 µm thick.

The resist film is then exposed to high-energy radiation from a light source selected from UV, deep-UV, electron beam, x-ray, excimer laser light, γ-ray and synchrotron radiation sources, preferably radiation having an exposure wavelength of up to 300 nm, directly or through a mask having a desired pattern. An appropriate exposure dose is about 1 to 200 mJ/cm², preferably about 10 to 100 mJ/cm² in the case of radiation exposure, and about 0.1 to 20 µC/cm², preferably about 3 to 10 µC/cm² in the case of EB exposure. Subsequently, the film is preferably baked on a hot plate at 60 to 150°C for about 1 to 20 minutes, more preferably 80 to 120°C for about 1 to 10 minutes (post-exposure baking = PEB).

Thereafter the resist film is developed with a developer in the form of an aqueous base solution, for example, an aqueous solution of 0.1-5 wt%, preferably 2-3 wt% tetramethylammonium hydroxide (TMAH) for 0.1 to 3 minutes, preferably 0.5 to 2 minutes by a conventional technique such as dip, puddle or spray technique. In this way, a desired resist pattern is formed on the substrate.

It is appreciated that the resist composition of the invention is suited for micropatterning using such high-energy radiation as deep UV with a wavelength of 254 to 193 nm, vacuum UV with a wavelength of 157 nm, electron beam, x-rays, soft x-rays, excimer laser light, γ-rays and synchrotron radiation. With any of the above-described parameters outside the above-described range, the process may sometimes fail to produce the desired pattern.

### EXAMPLE

Synthesis Examples, Comparative Synthesis Examples, Examples, and Comparative Examples are given below by way of illustration and not by way of limitation. The weight average molecular weight (Mw) and number average molecular weight (Mn) are determined by gel permeation chromatography (GPC) versus polystyrene standards. NMR is nuclear magnetic resonance.

### Synthesis Example 1

In a 500-mL flask were admitted 95.7 g of 4-acetoxystyrene, 6.6 g of 4-vinylbenzoic acid, 97.7 g of indene, and 150 g of toluene as a solvent. The reactor was cooled to -70°C in a nitrogen atmosphere, whereupon vacuum deaeration and nitrogen flow were repeated three times. The reactor was warmed up to room temperature, 29.3 g of 2,2'-azobis(2,4-dimethylvaleronitrile) was added as a polymerization initiator, and the reactor was further heated to 53°C, at which reaction was effected for 40 hours. The reaction solution was poured into 5.0 L of methanol for precipitation. The resulting white solids were filtered and vacuum dried at 40°C, obtaining 138 g of a white polymer. The polymer was dissolved in a mixture of 0.2 L methanol and 0.24 L tetrahydrofuran again, to which 70 g of triethylamine and 15 g of water were added. Deprotection reaction was allowed to occur. The reaction solution was neutralized with acetic acid, concentrated, and dissolved in 0.5 L of acetone. This was followed by precipitation, filtration and drying in the same way as above, obtaining 86.6 g of a white polymer.

The polymer was analyzed by ¹³C-NMR, ¹H-NMR and GPC, with the analytical results shown below.

### Copolymer compositional ratio (molar ratio)

4-hydroxystyrene:4-vinylbenzoic acid:indene = 71.4:3.7:24.9
Mw = 3,900
Mw/Mn = 1.96

This polymer is designated Polymer A.

### Synthesis Example 2

In a 500-mL flask were admitted 125.3 g of 4-acetoxystyrene, 6.2 g of 4-vinylbenzoic acid, 68.5 g of indene, and 150 g of toluene as a solvent. The reactor was cooled to -70°C in a nitrogen atmosphere, whereupon vacuum deaeration and nitrogen flow were repeated three times. The reactor was warmed up to room temperature, 27.9 g of 2,2'-azobis(2,4-dimethylvaleronitrile) was added as a polymerization initiator, and the reactor was further heated to 53°C, at which reaction was effected for 40 hours. The reaction solution was poured into 5.0 L of methanol for precipitation. The resulting white solids were filtered and vacuum dried at 40°C, obtaining 133 g of a white polymer. The polymer was dissolved in a mixture of 0.2 L methanol and 0.24 L tetrahydrofuran again, to which 70 g of triethylamine and 15 g of water were added. Deprotection reaction was allowed to occur. The reaction solution was neutralized with acetic acid, concentrated, and dissolved in 0.5 L of acetone. This was followed by precipitation, filtration and drying in the same way as above, obtaining 86.5 g of a white polymer.

The polymer was analyzed by ¹³C-NMR, ¹H-NMR and GPC, with the analytical results shown below.

### Copolymer compositional ratio (molar ratio)

4-hydroxystyrene:4-vinylbenzoic acid:indene = 77.2:3.7:19.1
Mw = 4,100
Mw/Mn = 1.83

This polymer is designated Polymer B.

### Synthesis Example 3

In a 500-mL flask were admitted 107.6 g of 4-acetoxystyrene, 8.6 g of 4-vinylbenzoic acid, 83.8 g of indene, and 150 g of toluene as a solvent. The reactor was cooled to -70°C in a nitrogen atmosphere, whereupon vacuum deaeration and nitrogen flow were repeated three times. The reactor was warmed up to room temperature, 28.7 g of 2,2'-azobis(2,4-dimethylvaleronitrile) was added as a polymerization initiator, and the reactor was further heated to 53°C, at which reaction was effected for 40 hours. The reaction solution was poured into 5.0 L of methanol for precipitation. The resulting white solids were filtered and vacuum dried at 40°C, obtaining 141 g of a white polymer. The polymer was dissolved in a mixture of 0.2 L methanol and 0.24 L tetrahydrofuran again, to which 70 g of triethylamine and 15 g of water were added. Deprotection reaction was allowed to occur. The reaction solution was neutralized with acetic acid, concentrated, and dissolved in 0.5 L of acetone. This was followed by precipitation, filtration and drying in the same way as above, obtaining 97.3 g of a white polymer.

The polymer was analyzed by ¹³C-NMR, ¹H-NMR and GPC, with the analytical results shown below.

### Copolymer compositional ratio (molar ratio)

4-hydroxystyrene:4-vinylbenzoic acid:indene = 75.3:4.5:20.2
Mw = 4,300
Mw/Mn = 1.89

This polymer is designated Polymer C.

### Comparative Synthesis Examples

Binary polymers were synthesized by the same procedure as in the foregoing Synthesis Examples. Their designation and analytical data are shown below.

### Polymer G

### Copolymer compositional ratio (molar ratio)

4-hydroxystyrene:indene = 78.1:21.9
Mw = 4,700
Mw/Mn = 1.85

### Polymer H

### Copolymer compositional ratio (molar ratio)

4-hydroxystyrene:4-methoxystyrene = 81.2:18.8 Mw = 5,000
Mw/Mn = 1.89

Polymers A to H synthesized above have the following structural formulae.

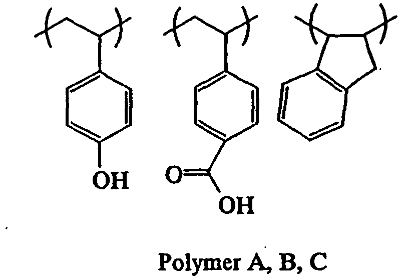

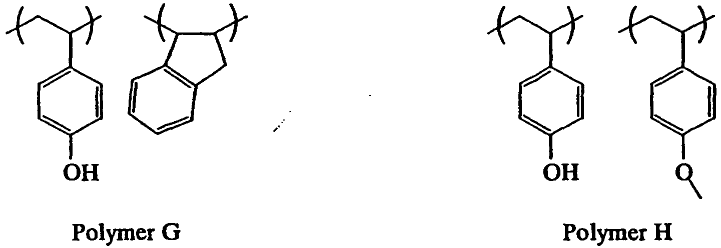

### Examples 1-4 & Comparative Examples 1-2

Resist compositions were prepared according to the formulation shown in Table 1 (in parts by weight). The polymers are Polymers A to H obtained in the above Synthesis Examples and Comparative Synthesis Examples. The remaining components listed in Table 1 have the following meaning.
- Crosslinker 1:: tetramethoxymethylglycoluril
- Crosslinker 2:: hexamethoxymethylmelamine
- PAG1:: triphenylsulfonium 4-(4'-methylphenyl-sulfonyloxy)phenylsulfonate
- PAG2:: bis(tert-butylsulfonyl)diazomethane
- Basic compound A:: tri-n-butylamine
- Basic compound B:: tris(2-methoxyethyl)amine
- Surfactant A:: FC-430 (Sumitomo 3M Co., Ltd.)
- Surfactant B:: Surflon S-381 (Asahi Glass Co., Ltd.)
- Solvent A:: propylene glycol methyl ether acetate
- Solvent B:: propylene glycol methyl ether

**Table 1**

| **Components (pbw)** | **Example** | | | | **Comparative Example** | |
|---|---|---|---|---|---|---|
| | 1 | 2 | 3 | 4 | 1 | 2 |
| Polymer A | 100 | | | | | |
| Polymer B | | 100 | 100 | | | |
| Polymer C | | | | 100 | | |
| Polymer G | | | | | 100 | |
| Polymer H | | | | | | 100 |
| Crosslinker 1 | | | 5 | | | |
| Crosslinker 2 | 10 | 10 | 5 | 10 | 10 | 10 |
| PAG1 | 5 | 5 | 5 | 5 | 5 | 5 |
| PAG2 | 1 | 1 | 1 | 1 | 1 | 1 |
| PAG3 | | | | | | |
| Basic compound A | 0.05 | 0.05 | | 0.05 | 0.05 | 0.05 |
| Basic compound B | 0.15 | 0.15 | 0.2 | 0.15 | 0.15 | 0.15 |
| Surfactant A | 0.1 | 0.1 | 0.05 | 0.1 | 0.1 | 0.1 |
| Surfactant B | | | 0.05 | | | |
| Solvent A | 240 | 240 | 240 | 240 | 240 | 240 |
| Solvent B | 420 | 420 | 420 | 420 | 420 | 420 |

Each of the resist compositions was filtered through a 0.2-µm Teflon^{®} filter and then spin-coated onto a silicon wafer so as to give a dry thickness of 0.35 µm. The coated wafer was then baked on a hot plate at 100°C for 4 minutes. The resist film was exposed to electron beam using an EB lithography system ELS-3700 (Elionix Co., Ltd., accelerating voltage 30 keV), then baked (PEB) at 110°C for 4 minutes, and developed with a solution of 2.38 wt% tetramethylammonium hydroxide in water, thereby giving a negative pattern.

The resulting resist patterns were evaluated as described below.

The optimum exposure dose (sensitivity Eop) was the exposure dose which provided a 1:1 resolution at the top and bottom of a 0.20-µm line-and-space pattern. The minimum line width (µm) of a line-and-space pattern which was ascertained separate at this dose was the resolution of a test resist. The shape in cross section of the resolved resist pattern was examined under a scanning electron microscope. Etching resistance was examined by dry etching a resist film with a 1:1 mixture of CHF₃ and CF₄ for 2 minutes and determining a reduction in thickness of the resist film. A smaller thickness reduction indicates better etching resistance.

The solubility of resist material in a solvent mixture was examined by visual observation and by inspecting any clogging during filtration.

With respect to the applicability of a resist solution, uneven coating was visually observed. Additionally, using a film gage Clean Track Mark 8 (Tokyo Electron Co., Ltd.), the thickness of a resist film on a common wafer was measured at different positions, based on which a variation from the desired coating thickness (0.4 µm) was calculated. The applicability was rated "good" when the variation was within 0.5% (that is, within 0.002 µm), "acceptable" when the variation was within 1%, and "poor" when the variation was more than 1%.

Debris appearing on the developed pattern was observed under a scanning electron microscope (TDSEM) model S-7280H (Hitachi Ltd.). The resist film was rated "good" when the number of foreign particles was up to 10 per 100 µm², "fair" when from 11 to 15, and "poor" when more than 15.

Debris left after resist peeling was examined using a surface scanner Surf-Scan 6220 (Tencol Instruments). After the resist film was peeled from a 203mm (8-inch) wafer, the wafer was examined and rated "good" when the number of foreign particles of equal to or greater than 0.20 µm was up to 100, "fair" when from 101 to 150, and "poor" when more than 150.

The results are shown in Table 2.

**Table 2**

| | Eop (µC/cm²) | Resolution (µm) | Thickness reduction by etching (Å) | Solubility | Debris on pattern | Debris after resist peeling |
|---|---|---|---|---|---|---|
| Example 1 | 4.4 | 0.07 | 765 | good | good | good |
| Example 2 | 5 | 0.06 | 779 | good | good | good |
| Example 3 | 5.2 | -0.06 | 793 | good | good | good |
| Example 4 | 5.6 | 0.07 | 788 | good | good | good |
| Comparative Example 1 | 6.7 | 0.12 | 801 | good | fair | good |
| Comparative Example 2 | 7.9 | 0.14 | 872 | good | poor | poor |

It should not need to be added that where ranges are given herein for the preferred values of parameters or amounts, the technical criteria for the upper and lower limits are naturally different, so that the upper and lower limits are independent proposals.

## Claims

1. A negative resist composition comprising a polymer comprising recurring units having the general formula (2) : 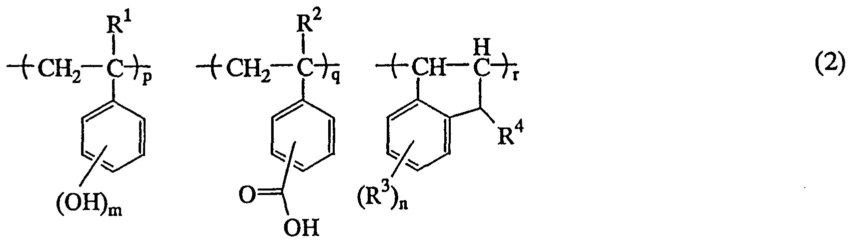 wherein R¹ and R² are hydrogen or methyl, R³ and R⁴ are independently selected from the class consisting of hydrogen atoms, hydroxy groups, methyl groups, alkoxycarbonyl groups, cyano groups and halogen atoms, m is 0 or a positive integer of 1 to 5, n is 0 or a positive integer of 1 to 4, and p, q and r are positive numbers, the polymer having a weight average molecular weight of 1,000 to 500,000.

2. A negative resist composition of claim 1 wherein the polymer has a weight average molecular weight of 2,000 to 6,000.

3. A negative resist composition of claim 1 in which, in formula (2), 0 < q/(p+q+r) ≤ 0.1.

4. A negative resist composition of claim 3 in which 0.01 ≤ q/(p+q+r) ≤ 0.07 and 0 < r/(p+q+r) ≤ 0.2.

5. A chemically amplified negative resist composition comprising
(A) organic solvent,
(B) polymer as defined in claim 1 or 2 as base resin, and
(C) crosslinker.

6. A chemically amplified negative resist composition comprising
(A) organic solvent,
(B) polymer as defined in claim 1 or 2 as base resin,
(C) crosslinker,
(D) photoacid generator.

7. A resist composition of claim 5 or 6, further comprising
(E) basic compound.

8. A resist composition of claim 7 in which the basic compound is selected from primary, secondary and tertiary aliphatic amines, mixed amines, aromatic amines, heterocyclic amines, nitrogen-containing compounds having carboxyl group, nitrogen-containing compounds having sulfonyl group, nitrogen-containing compounds having hydroxyl group, nitrogen-containing compounds having hydroxyphenyl group, alcoholic nitrogen-containing compounds, amide derivatives and imide derivatives.

9. A resist composition of any one of claims 5 to 8 in which the organic solvent is selected from butyl acetate, amyl acetate, cyclohexyl acetate, 3-methoxybutyl acetate, methyl ethyl ketone, methyl amyl ketone, cyclohexanone, cyclopentanone, 3-ethoxyethyl propionate, 3-ethoxymethyl propionate, 3-methoxymethyl propionate, methyl acetoacetate, ethyl acetoacetate, diacetone alcohol, methyl pyruvate, ethyl pyruvate, propylene glycol monomethyl ether, propylene glycol monoethyl ether, propylene glycol monomethyl ether propionate, propylene glycol monoethyl ether propionate, ethylene glycol monomothyl esther, ethylene glycol monoethyl ether, diethylene glycol monomethyl ether, diethylene glycol monoethyl ether, 3-methyl-3-methoxybutanol, N-methylpyrrolidone, dimethyl sulfoxide, γ-butyrolactone, propylene glycol alkyl ether acetates such as propylene glycol methyl ether acetate, propylene glycol ethyl ether acetate, and propylene glycol propyl ether acetate, alkyl lactates such as methyl lactate, ethyl lactate, and propyl lactate, and tetramethylene sulfone.

10. A resist composition of claim 9 in which the solvent is selected from propylene glycol alkyl ether acetates, alkyl lactates and mixtures thereof.

11. A process for forming a resist pattern, comprising the steps of:
applying a resist composition of any one of claims 1 to 10 onto a substrate to form a coating,
heat treating the coating and exposing the coating to high-energy radiation or electron beam through a photomask,
optionally heat treating the exposed coating, and developing the coating with a developer.

## Patentansprüche

1. Negativ-Resist-Zusammensetzung, die ein Polymer umfasst, das Grundeinheiten der allgemeinen Formel (2) umfasst: 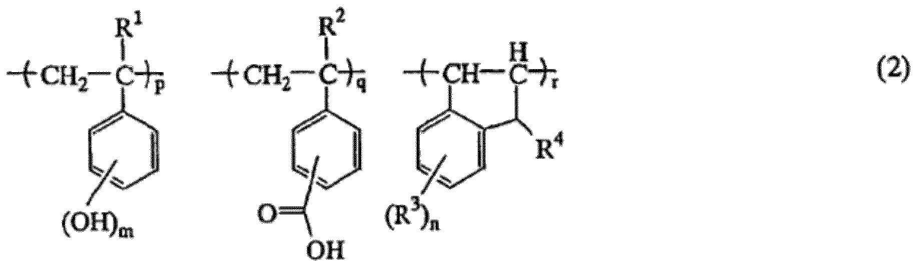 worin R¹ und R² Wasserstoff oder Methyl sind, R³ und R⁴ jeweils unabhängig voneinander aus der aus Wasserstoffatomen, Hydroxygruppen, Methylgruppen, Alkoxycarbonylgruppen, Cyanogruppen und Halogenatomen bestehenden Klasse ausgewählt sind, m = 0 oder eine positive ganze Zahl von 1 bis 5 ist, n = 0 oder eine positive ganze Zahl von 1 bis 4 ist und p, q und r positive Zahlen sind, wobei das Polymer ein gewichtsmittleres Molekulargewicht von 1.000 bis 500.000 aufweist.

2. Negativ-Resist-Zusammensetzung nach Anspruch 1, worin das Polymer ein gewichtsmittleres Molekulargewicht von 2.000 bis 6.000 aufweist.

3. Negativ-Resist-Zusammensetzung nach Anspruch 1, worin in Formel (2) gilt: 0<q:(p + q + r)≤0,2.

4. Negativ-Resist-Zusammensetzung nach Anspruch 3, worin gilt: 0,01 ≤ q:(p+q+r)≤0,07 und 0<r:(p+q+r)≤0,2.

5. Chemisch amplifizierte Negativ-Resist-Zusammensetzung, die Folgendes umfasst:
(A) organisches Lösungsmittel,
(B) Polymer wie in Anspruch 1 oder 2 definiert als Basisharz und
(C) Vernetzungsmittel.

6. Chemisch amplifizierte Negativ-Resist-Zusammensetzung, die Folgendes umfasst:
(A) organisches Lösungsmittel,
(B) Polymer wie in Anspruch 1 oder 2 definiert als Basisharz,
(C) Vernetzungsmittel,
(D) Photosäure-Bildner.

7. Resist-Zusammensetzung nach Anspruch 5 oder 6, die weiters Folgendes umfasst:
(E) basische Verbindung.

8. Resist-Zusammensetzung nach Anspruch 7, worin die basische Verbindung aus primären, sekundären und tertiären aliphatischen Aminen, gemischten Aminen, aromatischen Aminen, heterozyklischen Aminen, stickstoffhältigen Verbindungen mit Carboxylgruppe, stickstoffhältigen Verbindungen mit Sulfonylgruppe, stickstoffhältigen Verbindungen mit Hydroxylgruppe, stickstoffhältigen Verbindungen mit Hydroxyphenylgruppe, alkoholischen stickstoffhältigen Verbindungen, Amidderivaten und Imidderivaten ausgewählt ist.

9. Resist-Zusammensetzung nach einem der Ansprüche 5 bis 8, worin das organische Lösungsmittel aus Butylacetat, Amylacetat, Cyclohexylacetat, 3-Methoxybutylacetat, Methylethylketon, Methylamylketon, Cyclohexanon, Cyclopentanon, 3-Ethoxyethylpropionat, 3-Ethoxymethylpropionat, 3-Methoxymethylpropionat, Methylacetoacetat, Ethylacetoacetat, Diacetonalkohol, Methylpyruvat, Ethylpyruvat, Propylenglykolmonomethylether, Propylenglykolmonoethylether, Propylenglykolmonomethyletherpropionat, Propylenglykolmonoethyletherpropionat, Ethylenglykolmonomethylether, Ethylenglykolmonoethylether, Diethylenglykolmonomethylether, Diethylenglykolmonoethylether, 3-Methyl-3-methoxybutanol, N-Methylpyrrolidon, Dimethylsulfoxid, y-Butyrolacton, Propylenglykolalkyletheracetaten, wie z.B. Propylenglykolmethyletheracetat, Propylenglykolethyletheracetat und Propylenglykolpropyletheracetat, Alkyllactaten, wie z.B. Methyllactat, Ethyllactat und Propyllactat, und Tetramethylsulfon ausgewählt ist.

10. Resist-Zusammensetzung nach Anspruch 9, worin das Lösungsmittel aus Propylenglykolalkyletheracetaten, Alkyllactaten und Gemischen davon ausgewählt ist.

11. Verfahren zur Bildung eines Resist-Musters, das die folgenden Schritte umfasst:
das Aufbringen einer Resist-Zusammensetzung nach einem der Ansprüche 1 bis 10 auf ein Substrat, um einen Überzug zu bilden,
das Wärmebehandeln des Überzugs und das Aussetzen des Überzugs gegenüber energiereicher Strahlung oder Elektronenstrahlen durch eine Photomaske hindurch,
gegebenenfalls das Behandeln des exponierten Überzugs und das Entwickeln des Überzugs mit einem Entwickler.

## Revendications

1. Composition pour réserve de type négatif comprenant un polymère comprenant des unités récurrentes répondant à la formule générale (2) : 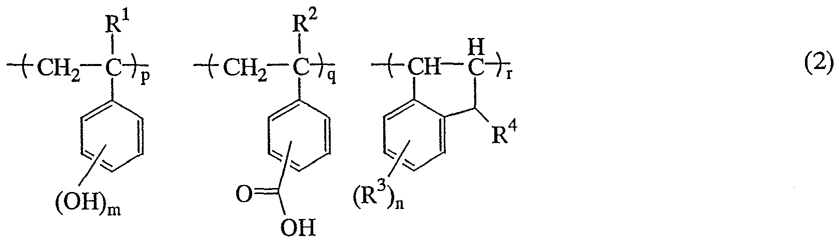 dans laquelle R¹ et R² représentent un atome d'hydrogène ou un groupe méthyle, R³ et R⁴ sont indépendamment choisis dans la classe constituée des atomes d'hydrogène, des groupes hydroxy, des groupes méthyles, des groupes alcoxycarbonyles, des groupes cyano et des atomes d'halogène, m vaut 0 ou est un nombre entier positif de 1 à 5, n vaut 0 ou est un nombre entier positif de 1 à 4, et p, q et r sont des nombres positifs, le polymère ayant un poids moléculaire moyen en poids de 1 000 à 500 000.

2. Composition pour réserve de type négatif selon la revendication 1 dans laquelle le polymère a un poids moléculaire moyen en poids de 2 000 à 6 000.

3. Composition pour réserve de type négatif selon la revendication 1 dans laquelle, dans la formule (2), 0 < q/(p + q + r) ≤ 0,1.

4. Composition pour réserve de type négatif selon la revendication 3 dans laquelle 0,01 ≤q/(p+q+r)≤0,07 et 0<r/(p+q+r)≤0,2.

5. Composition pour réserve de type négatif amplifiée chimiquement comprenant
(A) un solvant organique,
(B) un polymère selon la revendication 1 ou 2 sous la forme d'une résine de base, et
(C) un agent de réticulation.

6. Composition pour réserve de type négatif amplifiée chimiquement comprenant
(A) un solvant organique,
(B) un polymère selon la revendication 1 ou 2 sous la forme d'une résine de base,
(C) un agent de réticulation,
(D) un générateur de photo-acide.

7. Composition pour réserve selon la revendication 5 ou 6, comprenant en outre (E) un composé basique.

8. Composition pour réserve selon la revendication 7 dans laquelle le composé basique est choisi parmi les amines aliphatiques primaires, secondaires et tertiaires, les amines mixtes, les amines aromatiques, les amines hétérocycliques, les composés contenant de l'azote comportant un groupe carboxyle, les composés contenant de l'azote comportant un groupe sulfonyle, les composés contenant de l'azote comportant un groupe hydroxyle, les composés contenant de l'azote comportant un groupe hydroxyphényle, les composés alcooliques contenant de l'azote, les dérivés amide et les dérivés imide.

9. Composition pour réserve selon l'une quelconque des revendications 5 à 8 dans laquelle le solvant organique est choisi parmi l'acétate de butyle, l'acétate d'amyle, l'acétate de cyclohexyle, l'acétate de 3-méthoxybutyle, la méthyléthylcétone, la méthylamylcétone, la cyclohexanone, la cyclopentanone, le propionate de 3-éthoxyéthyle, le propionate de 3-éthoxyméthyle, le propionate de 3-méthoxyméthyle, l'acétoacétate de méthyle, l'acétoacétate d'éthyle, l'alcool de diacétone, le pyruvate de méthyle, le pyruvate d'éthyle, l'éther monométhylique de propylène glycol, l'éther monoéthylique de propylène glycol, le propionate d'éther monométhylique de propylène glycol, le propionate d'éther monoéthylique de propylène glycol, l'éther monométhylique d'éthylène glycol, l'éther monoéthylique d'éthylène glycol, l'éther monométhylique de diéthylène glycol, l'éther monoéthylique de diéthylène glycol, le 3-méthyl-3-méthoxybutanol, la N-méthylpyrrolidone, le sulfoxyde de diméthyle, la y-butyrolactone, les acétates d'éther alkylique de propylène glycol tels que l'acétate d'éther méthylique de propylène glycol, l'acétate d'éther éthylique de propylène glycol et l'acétate d'éther propylique de propylène glycol, les lactates d'alkyle tels que le lactate de méthyle, le lactate d'éthyle et le lactate de propyle, et la tétraméthylène sulfone.

10. Composition pour réserve selon la revendication 9 dans laquelle le solvant est choisi parmi les acétates d'éther alkylique de propylène glycol, les lactates d'alkyle et leurs mélanges.

11. Procédé de formation d'un motif de réserve, comprenant les étapes consistant à :
appliquer une composition pour réserve selon l'une quelconque des revendications 1 à 10 sur un substrat pour former un revêtement,
traiter à chaud le revêtement et exposer le revêtement à un rayonnement hautement énergétique ou à un faisceau électronique à travers un masque photographique,
optionnellement traiter à chaud le revêtement exposé, et développer le revêtement à l'aide d'un révélateur.
